(19) **Europäisches Patentamt**
**European Patent Office**
**Office européen des brevets**

(11) **EP 4 300 087 A1**

(12) **EUROPEAN PATENT APPLICATION**

(43) Date of publication:
**03.01.2024 Bulletin 2024/01**

(21) Application number: **22181883.4**

(22) Date of filing: **29.06.2022**

(51) International Patent Classification (IPC):
*G01N 23/2251* (2018.01)    *H01J 37/00* (2006.01)

(52) Cooperative Patent Classification (CPC):
**G01N 23/2251;** H01J 2237/221; H01J 2237/24592;
H01J 2237/2817; H01L 22/20

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **KUIPER, Vincent, Sylvester
5500 AH Veldhoven (NL)**
• **WIELAND, Marco, Jan-Jaco
5500 AH Veldhoven (NL)**

(74) Representative: **ASML Netherlands B.V.
Corporate Intellectual Property
P.O. Box 324
5500 AH Veldhoven (NL)**

(54) **METHOD OF PROCESSING DATA DERIVED FROM A SAMPLE**

(57)    The present invention provides a method of processing data derived from a sample, comprising processing an initial data set of elements derived from a detection by a detector for calibration, the data set comprising elements representing nuisance signals and detection signals. The processing of the initial data set comprising: fitting a distribution model to the initial data set to create a nuisance distribution model; setting a signal strength value, and selecting elements in the initial data set having a magnitude greater than the signal strength value as a set of defect candidates; fitting a distribution model to the set of defect candidates to create a defect distribution model of detection signals; and determining a signal strength threshold dependent on at least the defect distribution model. The determining comprising correcting the defect distribution model.

Fig. 5

EP 4 300 087 A1

**Description**

FIELD

The embodiments provided herein generally relate to methods of processing data derived from a sample, methods of identifying defect candidates and assessment systems.

BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

In order to identify genuine defects on the object under inspection, it is preferable to first discard nuisance signals, caused for example by noise. In this way, a situation in which time and resources are spent performing more detailed analyses on the potentially large amount of nuisance signals can be avoided. The nuisance signals are often identified as those signals having a signal strength below a certain threshold value. Signals having a signal strength equal to or greater than the threshold value are considered to be likely defect signals which may then undergo further analysis to determine whether a defect exists and if so to classify the nature of the defect. The value of the threshold is typically set using experience through trial and error. This trial and error process can be time consuming and it can be difficult to verify that the chosen value is suitable. If the threshold value is set too high, there is a risk that genuine defects may be missed due to being associated with a signal strength lower than the threshold value. If the threshold is set too low, a large number of nuisance signals will be included in the data set for further analysis. This can make the further analysis time consuming and inefficient.

SUMMARY

It is an object of the present disclosure to provide embodiments of methods of processing data derived from a sample, methods of identifying defect candidates and assessment systems.

According to a first aspect of the invention, there is provided a method of processing data derived from a sample, comprising processing an initial data set of elements derived from a detection by a detector for calibration, the data set comprising elements representing nuisance signals and detection signals. The processing of the initial data set comprises: fitting a distribution model to the initial data set to create a nuisance distribution model; setting a signal strength value, and selecting elements in the initial data set having a magnitude greater than the signal strength value as a set of defect candidates; fitting a distribution model to the set of defect candidates to create a defect distribution model of detection signals; and determining a signal strength threshold dependent on at least the defect distribution model. The determining comprises correcting the defect distribution model. Desirably the correcting being suitable for correcting for overlap in magnitude between elements representative of nuisance signals and detection signals.

According to a second aspect of the invention, there is provided a method of processing data derived from a sample, comprising processing an initial data set of elements derived from a detection by a detector for calibration, the data set comprising elements representing nuisance signals and detection signals. The processing of the initial data set comprises: fitting a distribution model to the initial data set to create a nuisance distribution model; setting a signal strength value and selecting elements in the initial data set having a magnitude greater than the signal strength value as a set of defect candidates; fitting a distribution model to the set of defect candidates to create a defect distribution model of detection signals; determining a signal strength threshold dependent on at least the defect distribution model; and determining a relationship between capture rate and the signal strength threshold.

According to a third aspect of the invention, there is provided a method of processing data derived from a sample, comprising processing an initial data set of elements derived from a detection by a detector. The data set comprises elements representing nuisance signals and defect signals. A nuisance distribution comprises the elements representing nuisance signals having a nuisance range in magnitude. A defect distribution comprises the elements representing defect signals having a defect range in magnitude. The nuisance range overlaps with the defect range. The nuisance range overlaps with the defect range in an overlap. At least one element of the defect range has a magnitude exceeding an upper limit of the nuisance range in magnitude.

According to a fourth aspect of the invention, there is provided a method of identifying defect candidates, comprising processing a data set of elements derived from a detection by a detector, the data set comprising elements representing nuisance signals and detection signals. A capture-threshold relationship between capture rate and a signal strength threshold having been calibrated using an initial data set. The processing comprising: setting a signal strength threshold by selecting a capture rate and based on the capture-threshold relationship; and processing the data set using the signal strength threshold to select elements representative of detection signals.

According to a fifth aspect of the invention, there is provided an assessment system identifying defect candidates in inspection data derived from a sample. The assessment system comprises: a detector and a processor. The detector is configured to generate a detection signal representative of a one more characteristics of a sample. The processor is configured to: process a data set of elements derived from a detection by the detector, the data set comprising elements representing nuisance signals and detection signals; set a signal strength threshold by selecting a capture rate and based on a capture-threshold relationship between capture rate and a signal strength threshold, the capture relationship calibration being pre-calibrated with an initial data set; and process the data set using the signal strength threshold to select elements representative of detection signals.

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary electron beam inspection apparatus.
FIG. 2 is a schematic diagram illustrating an exemplary multi-beam charged particle assessment system that is part of the exemplary electron beam inspection apparatus of FIG. 1.
FIG. 3 is a schematic diagram of an exemplary multi-beam charged particle assessment system according to an embodiment.
FIG. 4 is a schematic diagram of an exemplary multi-beam charged particle assessment system according to an embodiment.
FIG. 5 is an exemplary histogram of signal strength data derived from a sample.
FIG. 6A is an exemplary graphical representation of the summed distribution model, the actual distribution of the initial dataset, the defect distribution model and the nuisance distribution model and FIG. 6B is a magnified view of a region of FIG. 6A.
FIG. 7A is an exemplary plot of nuisance rate against capture rate; FIG. 7B is an exemplary plot of capture rate against signal strength threshold.
FIG. 8A and 8B are further examples comparing the corrected distribution models with the corresponding actual data.
FIG. 9 is a graphical representation of the distribution of an exemplary initial data set, including a model of the distribution of nuisance signals.
FIG. 10A and 10 B is a graphical representation of the distribution of two further exemplary initial data sets, including corresponding models of the distribution of nuisance signals having different gradients.
FIG. 11 is a graphical representation of the distribution of a further exemplary initial data set, including corresponding models of the distribution of nuisance signals, where the nuisance range and defect range overlap.
FIG. 12A-D are schematic diagrams depicting images of samples each having a plurality of features and a defect.

The schematic diagrams and views show the components described below. However, the components depicted in the figures are not to scale.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an inspection apparatus may utilize a single primary electron beam incident on a sample. For high throughput inspection, some of the inspection apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam inspection apparatus can therefore inspect a sample at a much higher speed than a single-beam inspection apparatus.

An implementation of known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

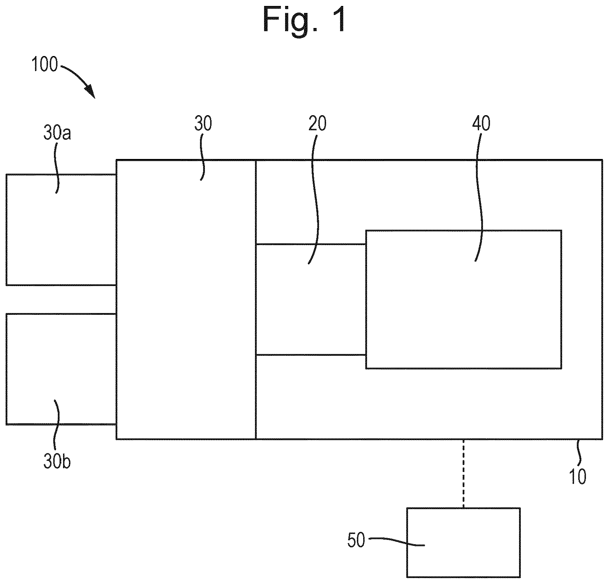

Reference is now made to **FIG. 1,** which is a schematic diagram illustrating an exemplary charged particle beam inspection apparatus 100. The charged particle beam inspection apparatus 100 of **FIG. 1** includes a main chamber 10, a load lock chamber 20, a charged particle assessment system 40 (which may also be called an electron beam system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be inspected. The charged particle assessment system 40 comprises an electron-optical system 41. The term 'electron-optical device' may be synonymous with the electron-optical system 41. The electron-optical system 41 may be a multi-beam electron-optical system 41 configured to project a multi-beam towards the sample, for example the sub-beams being arranged with respect to each other in a multi-beam arrangement. Alternatively, the electron-optical system 41 may be a single beam electron-optical system 41 configured to project a single beam towards the sample.

The controller 50 is electronically connected to the charged particle assessment system 40. The controller 50 may be a processor (such as a computer) configured to control the charged particle beam inspection apparatus 100. The controller 50 may also include a processing circuitry configured to execute various signal and image processing functions. While the controller 50 is shown in FIG. 1 as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

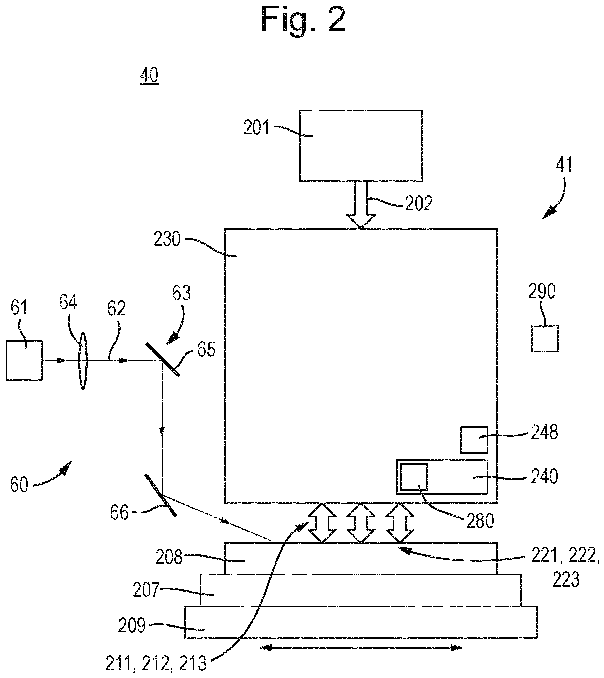

Reference is now made to **FIG. 2,** which is a schematic diagram illustrating an exemplary charged particle assessment system 40 including a multi-beam electron-optical system 41 that is part of the exemplary charged particle beam inspection apparatus 100 of **FIG. 1.** The multi-beam electron-optical system 41 comprises an electron source 201 and a projection apparatus 230. The charged particle assessment system 40 further comprises an actuated stage 209 and a sample holder 207. The sample holder may have a holding surface (not depicted) for supporting and holding the sample. Thus the sample holder may be configured to support the sample. Such a holding surface may be an electrostatic clamp operatable to hold the sample during operation of the electron optical system 41 e.g. assessment or inspection of the sample. The holding surface may be recessed into sample holder, for example a surface of the sample holder orientated to face the electron optical system 41. The electron source 201 and projection apparatus 230 may together be referred to as the electron-optical system 41. The sample holder 207 is supported by actuated stage 209 so as to hold a sample 208 (e.g., a substrate or a mask) for inspection. The multi-beam electron-optical system 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam inspection apparatus 100 of **FIG. 1,** such as the electron source 201, the detector 240, the projection apparatus 230, and the actuated stage 209. The controller 50 may perform various image and signal processing functions. The controller 50 may also generate various control signals to govern operations of the charged particle beam inspection apparatus, including the charged particle multi-beam apparatus.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy $\leq$ 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2).** However, the signal processing system 280 may be incorporated into any components of the inspection apparatus 100 or multi-beam charged particle assessment system 40, such as, as part of the projection apparatus 230 or the controller 50. The signal processing system 280 may be physically separate from the projection apparatus 230 and the controller 50, for example in a different room. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of the primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the actuated stage 209 to move sample 208 during inspection of the sample 208. The controller 50 may enable the actuated stage 209 to move the sample 208 in a direction, preferably continuously, for example at a constant speed, at least during sample inspection. The controller 50 may control movement of the actuated stage 209 so that it changes the speed of the movement of the sample 208 dependent on various parameters. For example, the controller 50 may control the stage speed (including its direction) depending on the characteristics of the inspection steps of scanning process.

Known multi-beam systems, such as the charged particle assessment system 40 and charged particle beam inspection apparatus 100 described above (and elsewhere described herein), are disclosed in US2020118784, US20200203116, US 2019/0259570 and US2019/0259564 which are hereby incorporated by reference.

As shown in **FIG. 2,** in an embodiment the charged particle assessment system 40 comprises a projection assembly 60. The projection assembly 60 may be a module and may be referred to as an ACC module. The projection assembly 60 is arranged to direct a light beam 62 such that the light beam 62 enters between the electron-optical system 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

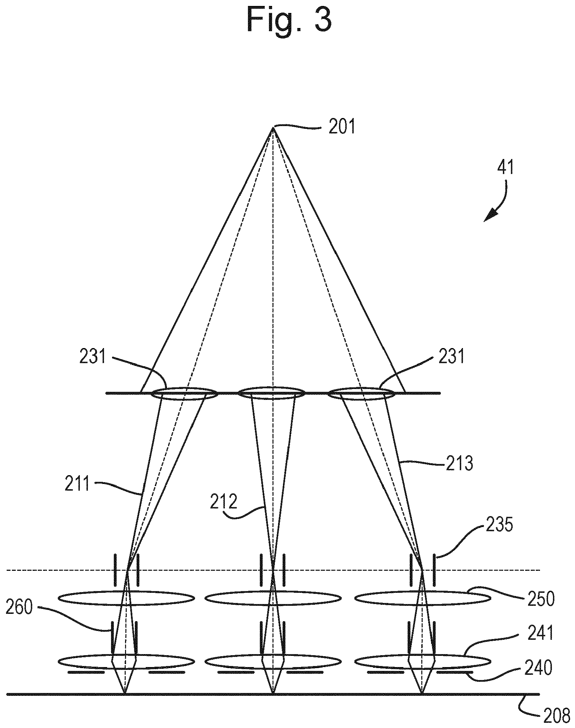

Components of a charged particle assessment system 40 which may be used in the present invention are described below in relation to **FIG. 3** which is a schematic diagram of a charged particle assessment system 40. The charged particle assessment system 40 of **FIG. 3** may correspond to the charged particle assessment system 40 (which may also be referred to as an apparatus or a tool) mentioned above.

The electron source 201 directs electrodes toward an array of condenser lenses 231 (otherwise referred to as a condenser lens array). The electron source 201 is desirably a high brightness thermal field emitter arranged to operate within an optimized electron-optical performance range that is a compromise between brightness and total emission current (such a compromise may be considered to be a 'good' compromise'). There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

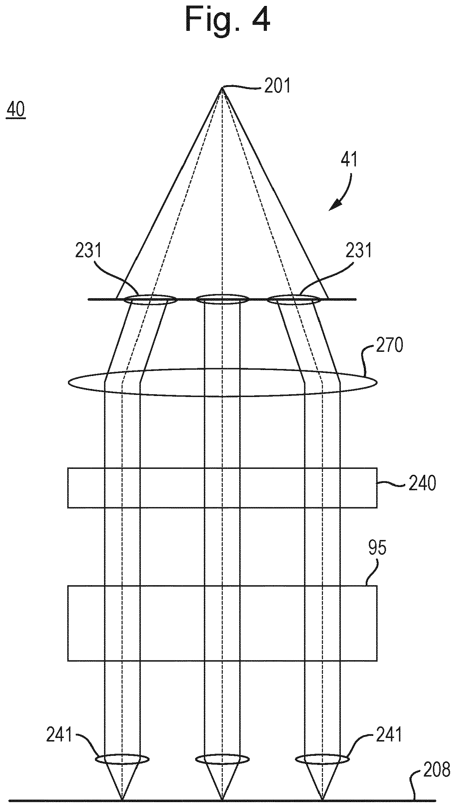

Each condenser lens 231 in the array directs electrons into a respective sub-beam 211, 212, 213 which is focused at a respective intermediate focus downbeam of the condenser lens array. The sub-beams diverge with respect to each other. In an embodiment, deflectors 235 are provided at the intermediate focuses. The deflectors 235 are positioned in the sub-beam paths at, or at least around, the position of the corresponding intermediate points of focus. The deflectors 235 are positioned in or close to the sub-beam paths at the intermediate image plane of the associated sub-beam. The deflectors 235 are configured to operate on the respective sub-beams 211, 212, 213. The deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the sub-beams so that before the deflectors, the sub-beam paths with respect to each other are diverging. Downbeam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. The collimator may comprise a macro collimator 270 (e.g. as shown in **FIG. 4),** instead of, or in addition to the deflectors 235. Thus, the macro-collimator 270 described below in relation to **FIG. 4** may be provided with the features of FIG. 3. This is generally less preferred than providing the collimator array as deflectors 235.

Below (i.e. downbeam or further from source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned upbeam of the objective lens array 241.

The control lens array 250 comprises a control lens for each sub-beam 211, 212, 213. A function of the control lens array 250 is to optimize the beam opening angle with respect to the demagnification of the beam and/or to control the beam energy delivered to the objective lens array 241 which directs the sub-beams 211, 212, 213 onto the sample 208. The objective lens array 241 may be positioned at or near the base of the electron-optical system 41. The control lens array 250 is optional, but is preferred for optimizing a sub-beam upbeam of the objective lens array.

The control lens array 250 may be considered as providing electrodes additional to the electrodes of the objective lens array 241 for example. The objective lens array 241 may have any number of additional electrodes associated and proximate to the objective lens array 241, for example five, seven, ten, or fifteen. The additional electrodes such as of the control lens array 250 allow further degrees of freedom for controlling the electron-optical parameters of the sub-beams. Such additional associated electrodes may be considered to be additional electrodes of the objective lens array 241 enabling additional functionality of the respective objective lenses of the objective lens array 241. In an arrangement such electrodes may be considered part of the objective lens array 241 providing additional functionality to the objective lenses of the objective lens array 241. Thus, the control lens is considered to be part of the corresponding objective lens, even to the extent that the control lens is only referred to as being a part of the objective lens.

For ease of illustration, lens arrays are depicted schematically herein by arrays of oval shapes (as shown in **FIG. 3).** Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

Optionally, an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

Any of the objective lens array assemblies described herein may further comprise a detector 240. The detector detects electrons emitted from the sample 208. The detected electrons may include any of the electrons detected by an SEM, including secondary and/or backscattered electrons emitted from the sample 208. An exemplary construction of a detector 240 is shown in **FIG. 3.**

**FIG. 4** schematically depicts a charged particle assessment system 40 according to an embodiment. Features that are the same as those described above are given the same reference numerals. For conciseness, such features are not described in detail with reference to **FIG. 4.** For example, the source 201, the condenser lenses 231, the objective lens array 241 and the sample 208 may be as described above.

In the example shown, a collimator is provided upbeam of the objective lens array assembly. The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses.

As described above, in an embodiment the detector 240 is between the objective lens array 241 and the sample 208. The detector 240 may face the sample 208. Alternatively, as shown in **FIG. 4,** in an embodiment the objective lens array 241, which comprises the plurality of objective lenses, is between the detector 240 and the sample 208.

In an embodiment a deflector array 95 is between the detector 240 and the objective lens array 241. In an embodiment the deflector array 95 comprises a Wien filter (or even a Wien filter array) so that deflector array may be referred to as a beam separator. The deflector array 95 is configured to provide a magnetic field to disentangle the charged particles projected to the sample 208 from the secondary electrons from the sample 208.

In an embodiment the detector 240 is configured to detect signal particles by reference to the energy of the charged particle, i.e. dependent on a band gap. Such a detector 240 may be called an indirect current detector. The secondary electrons emitted from the sample 208 gain energy from the fields between the electrodes. The secondary electrodes have sufficient energy once they reach the detector 240.

The invention can be applied to various different tool architectures of which the arrangements depicted and described with reference to **FIG. 3 and 4** are exemplary multi-beam arrangements. For example, the charged particle assessment system 40 may be a single beam tool for example US 20210319977 A1, or may comprise a plurality of single beam columns (or devices) or may comprise a plurality of columns of multi-beams. The columns may comprise the electron-optical system 41 described in any of the above embodiments or aspects. As a plurality of columns (or a multi-column tool) for example of columns projecting a plurality of beams towards a sample (or a multi-beam column) for example as depicted in and described with reference to **FIG. 3 and 4,** the devices may be arranged in an array which may number two to one hundred columns or more. The charged particle assessment system 40 may take the form of an embodiment as described with respect to and depicted in **FIG. 3,** although preferably having an electrostatic scan deflector array and an electrostatic collimator array. A charged particle column may optionally comprise a source.

As shown in **FIG. 2** (when read in context of the electron optical devices 41 as depicted in and described with respect to **FIGs 3 to 4),** in an embodiment the projection assembly 60 comprises an optical system 63. In an embodiment, the projection system 60 comprises a light source 61. The light source 61 is configured to emit the light beam 62. In an embodiment the light source 61 is a laser light source. Laser light provides a coherent light beam 62. However, other types of light source can alternatively be used. As mentioned above the projection assembly 60 is used to illuminate a light beam 62 on the sample 208 so as to control the accumulated charges due to effects such as photoconductivity, photoelectric, or thermal effects; and thus regulate the accumulated charges on the sample.

In an embodiment the optical system 63 comprises a lens, for example a cylindrical lens 64. The cylindrical lens 64 is configured to focus the light beam 62 more in one direction than in an orthogonal direction. The cylindrical lens increases the design freedom for the light source 61. In an embodiment the light source 61 is configured to emit a light beam 62 having a circular cross section. The cylindrical lens 64 is configured to focus the light beam 62 such that the light beam has an elliptical cross section. Even if a lens other than a cylindrical lens is used, the lens is positioned and designed to ensure the light beam reaches a portion of the sample required to be illuminated despite the small dimension between the sample and the most downbeam surface of the electron optical device 41 and the large dimension of the downbeam surface of the electron-optical device orthogonal to the orientation of the beam path. For the light beam to reach the sample surface, the beam may reflect off one more reflecting surfaces 65, 66 such as mirrors. Use of reflecting surfaces 65, 66 may improve the reach of the light beam 62 between the most downbeam surface of the electron optical device and the sample

As explained above, in an embodiment the charged particle assessment system 40 comprises a detector 240 configured to detect signal particles emitted by the sample 208. As shown in FIG. 3, in an embodiment, the detector 240 forms the most downbeam, with respect to the electron beam 211, 212, 213, surface of the electron-optical device 41. In other arrangements, as mentioned herein, the detector 240 may be associated with, and even comprise part of, the objective lens arrangement. For example the detector 240 may be associated with the objective lens array but a different position along the primary beam path, such associated with an electrode of the objective lens array, just upbeam of the objective lens array, distributed at different positions along the beam path in proximity and within the objective lens array or proximally positioned to the objective lens array. In another arrangement the detector is located in a secondary column adjoining or connected to the charged particle column comprising the electron-optical device 41. In all these arrangements there is a most downbeam element of the electron-optical system, such as detector 240, most proximate to the sample. The most downbeam surface of the most downbeam element may face the sample. The most downbeam surface may be referred to as a facing surface.

In order to detect defects on a sample, data derived from the sample is processed. The data may be derived, for example, from optical inspection of a sample. The data may be derived from the inspection of a sample by a charged particle assessment system 40, as shown in **FIG. 1-4**. For example, data detected by a detector (such as detector 240) may be compared with the corresponding expected data for a sample without any defects, the difference between the detected data and the expected data may represent a combination of genuine defects and nuisance signals, caused for example by noise. The nuisance signals are often identified as those signals having a signal strength below a certain threshold value. Signals having a signal strength equal to or greater than the threshold value are considered to be likely defect signals which may then undergo further analysis to determine whether a defect exists and if so to classify the nature of the defect. It is desirable to have a method to identify a suitable threshold value such that the number of genuine defects being omitted may be low without unnecessarily post-processing a large amount of nuisance signals.

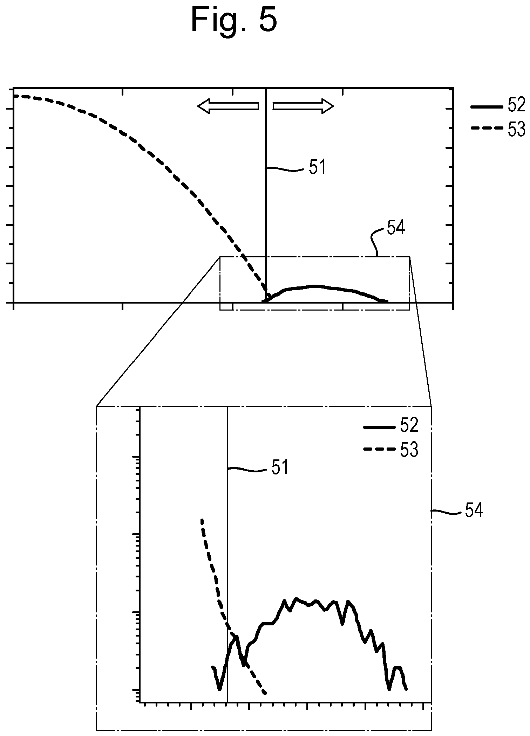

**FIG. 5** shows a histogram of an exemplary initial data set comprising elements representing nuisance signals 53 and defect signals 52. Such elements may be referred to as data elements. So the initial data set has a distribution of elements comprised of a distribution of nuisance signals 53 and a distribution of defect signals 52. The distribution of defect signals 52 is representative of actual defects. The X-axis of **FIG. 5** represents signal magnitude and the Y-axis of **FIG. 5** represents the number of occurrences of individual signals, for example of defect or nuisance, at each signal magnitude. **FIG. 5** also shows an exemplary threshold value 51. The threshold value is a signal magnitude which can be used to differentiate between a signal that is a nuisance signal and a defect signal. When applying the threshold value, a signal that has a larger magnitude than the threshold value is considered a detection signal (which is considered as likely to be an actual defect signal); a signal that has a smaller magnitude than the threshold value is considered as a nuisance signal. For data gathered during sample inspection in a data set, it will not be known in advance which elements of the data set represent nuisance signals and which represent actual defects. An appropriate threshold value therefore needs to be determined and applied in order to select the most suitable defect candidate data for further analysis. **FIG. 5** provides an insert of a magnified view 54 of the region of most interest. In this region of the histogram, there is an overlap of the distribution of nuisance signals 53 and the distribution of defect signals 52. The overlap has nuisance signals 53 and defect signals 52 that have same signal strength value. Within the overlap, the initial data set comprises a contribution of nuisance signals 53 and a contribution of defect signals 52. The threshold value cuts through the overlap separating the overlap into two parts. Each part of the two parts of the overlap comprises elements of the initial data set that are mix of actual nuisance signals and actual defect signals; yet the elements above the threshold value are classed as detection signals (which are those signals to be considered as likely defect signals). Elements of the overlap below the threshold value are classed as nuisance signals. Therefore some of the actual defect signals may be classed as nuisance. Some of the nuisance may be classed as defects, i.e. incorrectly identified as defects.

In using the threshold value to distinguish between defect signals and nuisance signals, as the threshold value is increased, the likelihood of a defect falling below the threshold value is increased. As the threshold value is decreased, the number of occurrences of nuisance signals increases. Consequently, if the threshold value is set too low a large number of signals, not representative of actual defects, which have been incorrectly identified signals as defects, then undergo further analysis i.e. as if they were defects, which is inefficient. The incorrectly identified signals as defects would provide inaccurate assessment information, e.g., assessment data (such as inspection data). Whereas, if the threshold value is set too high the capture rate of defects may be low. Here the capture rate is a measure of the ratio or percentage of elements of the data set representing actual defects which are equal to or greater than the threshold value. Capture rate may be defined as the percentage of data elements representing actual defects which were identified as defect candidates.

The present disclosure provides a method of processing data derived from a sample, comprising processing an initial data set of elements. The initial data set of elements is derived from a detection by a detector for calibration. The sample may be the sample 207, as described above with reference to **FIG. 2,** and the detector may be a detector 240, as described above with reference to **FIG. 2-4** or any of the other assessment systems herein disclosed such as a single beam system or a multi-column system. The processing of data may be performed using the signal processing system 280, as described above with reference to **FIG. 2.** The processing may be performed with the inspection apparatus such as in the column (or device) or may be performed at a remote location such as a processing rack remote from the location of the column, or the processing may be distributed for example so that part of the processing within the apparatus and part is remote such at a processing rack. The data may be stored and processed at a later time or processing may be concurrent with ongoing detection of data of the sample. A computer program (which may take the form of a group of programs that may be distributed over multiple processors) may provide instructions configured to control the processor to perform the processing of the data.

As shown, for example, in **FIG. 5,** the initial data set comprises elements representing nuisance signals 53 and defect signals 52. The processing of the initial data set comprises fitting a distribution model to the initial data set to create a nuisance distribution model. The nuisance distribution model is desirably a model representative of the distribution of the initial data set. The initial data set may have a substantially normal distribution, due to comprising predominantly nuisance signals representative of noise. The nuisance distribution model may, for example, comprise a Gaussian function. The number of data elements of the initial data set representative of actual defects is expected to be significantly lower than the number of elements of the initial data set representative of nuisance signals. Consequently, a preliminary model of the distribution of nuisance signals that is reasonably accurate can be determined by fitting a model to the whole initial data set. The preliminary model is referred to as 'reasonably accurate' because the initial data set includes signals representative of actual defects, as well as nuisance signals. Since the nuisance distribution model is based on the initial data which includes signals representative of actual defects, there is an error in the nuisance distribution model. However the population of the actual defects within the initial data set is so much smaller than the population of the nuisance signals (as will be mentioned later herein) that it can be considered negligible.

The processing of the initial data set further comprises setting a signal strength value and selecting elements in the initial data set having a magnitude greater than the signal strength value as a set of defect candidates. The signal strength value acts similarly to the threshold value 51 of **FIG. 5.** The data elements having a single strength magnitude above the selected signal strength value are those elements considered most likely to represent actual defects. A distribution model is fitted to the set of defect candidates to create a defect distribution model of detection signals. The detection signals are expected to comprise the majority of the defect signals. However, it is possible that some nuisance signals, representative of noise, may also be included in the set of defect candidates, or that some signals representing actual defects may be omitted from the set of defect candidates due to having a signal strength magnitude below the signal strength value. Nonetheless, the defect distribution model of detection signals is intended as a preliminary model representative of the distribution of signals representing defects in the sample. The set of defect candidates may have a substantially normal distribution. The defect distribution model may, for example, comprise a Gaussian function.

The processing of the initial data set further comprises determining a signal strength threshold dependent on at least the defect distribution model. In other words, the defect distribution model may be used to determine an appropriate signal strength threshold, above which it is anticipated that an appropriate proportion of the signals representing defects would be captured.

The determining the signal strength threshold comprises correcting the defect distribution model. Desirably the correcting is suitable for correcting for overlap in magnitude between elements representative of nuisance signals and defect signals. This is advantageous in scenarios where the initial data set has no clear dip or local minimum value. Below the local minimum value, the data is predominantly or wholly comprising nuisance signals. Above the local minimum value, the data is predominantly or wholly comprising data representative of actual defects. During inspection of some samples, it is found that there is an overlap, such as shown in the magnified view 54 of **FIG. 5,** between the nuisance signals 53 and the defect signals 52. Due to the overlap there may not be a local minimum in the number of occurrences of the initial data set to indicate a suitable value for the signal strength threshold. For example when the initial data set is considered as a whole before the data has been categorized as: nuisance signals; and detection signals (which are the candidates considered as possible defect signals).

Furthermore, in these scenarios, the defect distribution model initially created may not be an accurate representation of the distribution of data representing actual defects: due for example to the signal strength value being set to include too many nuisance signals or too few defect signals; and/or due to the large overlap in nuisance and defect signals. A large overlap in nuisance and defect signals may mean that it is not possible to effectively separate the two sets of data using a simple cut-off such as the signal strength value. It is therefore preferable to correct for the overlap to obtain a more representative corrected defect distribution model for use in setting the signal strength threshold used to filter out the data for further processing and omit the data deemed unnecessary.

The correcting for overlap may comprise correcting to a corrected defect distribution model of detection signals. The correcting for overlap preferably comprises creating a summed distribution model of the initial data set using the nuisance distribution model and the defect distribution model. Creating the summed distribution model may comprise summing the nuisance distribution model and the defect distribution model. The summed distribution model is therefore a model representative of the entire initial data set by combining the nuisance distribution model and the defect distribution model. This is because, as shown for example in **FIG. 5,** the initial data set is expected to comprise both the nuisance signals 53 and the defect signals 52.

Once a summed distribution model has been created, the summed distribution model can be improved by fitting the summed distribution model to an actual distribution of the initial dataset. The fitting of the summed distribution model means updating parameter values of the model until it matches more closely to the distribution of the initial data set. The updated summed distribution model may be referred to as a corrected summed distribution model. The model is deemed "corrected" because the model that has been subjected to the fitting is likely to match more closely the data that is subject to the modeling than is the model that has not been subjected to fitting.

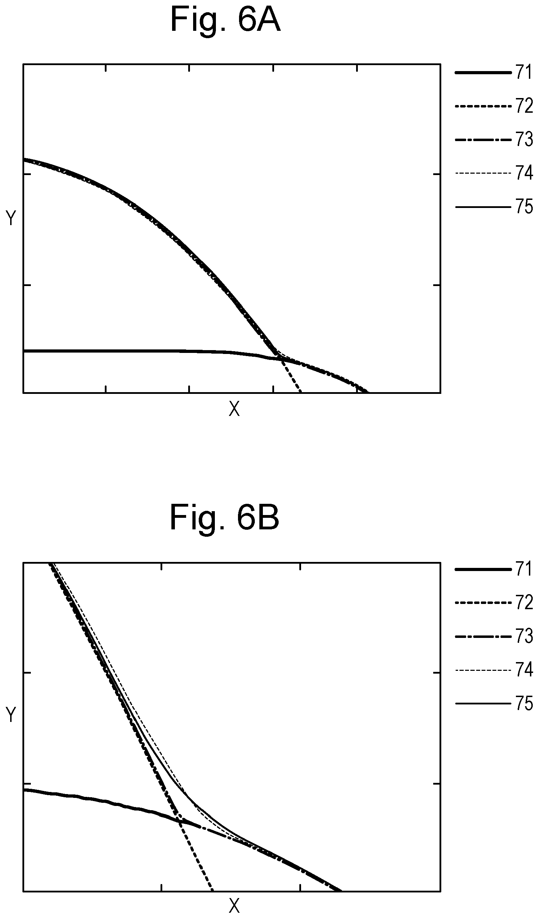

For example, **FIG. 6A** shows a graph representing the defect distribution model 71 (thick continuous line), the nuisance distribution model 72 (thick dashed line), the summed distribution model 73 (or the original summed distribution model) (thick dot-dash line), the corrected summed distribution model 74 (thin dashed line) and the distribution of the initial data set 75 (thin continuous line), where the X-axis is representative of signal strength magnitude and the Y-axis is representative of occurrences for example of signals with a specific signal strength magnitude. Since the details of FIG. 6A may be difficult to discern, **FIG. 6B** provides a magnified view of the region of most interest from **FIG. 6A.** As can be seen from **FIG. 6B,** the corrected summed distribution model 74 provides a closer approximation of the distribution of the initial data set 75 than is shown by the original summed distribution model 73.

There are commonly many more nuisance signals than defect signals by several orders of magnitude. For example, the distribution of nuisance signals may have order $10^{10}$ elements and the distribution of defect signals may have $10^2$. This can make it difficult to account for the relative significance of the nuisance and defect distribution models when fitting the summed distribution model. The summed distribution model and the actual distribution may each be a log of the inverse of a respective cumulative distribution. Desirably, the corrected summed distribution model is function, specifically a log of the inverse, of a respective cumulative distribution. Application of this function may reduce the difference in order of magnitude, for example reducing the signal strength magnitude required for the graphs of the distributions as shown in **FIG. 6A and 6B,** and thus of the length of the Y-axis.

The correcting for overlap may comprise creating the corrected defect distribution model by adjusting parameter values of the defect distribution model based on parameter values of the corrected summed distribution model. Alternatively, the correcting for overlap comprises creating the corrected defect distribution model based on parameter values of the corrected summed distribution model associated with the defect distribution model. Note that the corrected summed distribution is associated with the nuisance distribution model; in fact by definition corrected summed distribution is associated to both the defect distribution model and the nuisance distribution model. A corrected nuisance distribution model may therefore be created, for example based on parameter values of the corrected summed distribution model associated with the nuisance distribution model.

In either case of correcting for overlap, the corrected defect distribution model is expected to be a better match to the actual distribution of signals representing defects in the initial data. This is because the parameter values used in the corrected defect distribution model are based on parameter values in the corrected summed distribution model. The corrected summed distribution model may be considered to be a better match because it has been correlated to the distribution of the initial data set.

Setting the signal strength threshold is preferably based on parameter values of the corrected defect distribution model. This is because the corrected defect distribution model can be used to establish what signal strength threshold is needed to capture a sufficient amount of the data expected to be representative of defects. The sufficient amount may be determined for example by a user or a preselected use case. For example a sufficient amount is at least ninety percent (90%), for example between 90% and substantially 100%.

Furthermore, it is desirable to determine a relationship between capture rate and the signal strength threshold. In particular, it is desirable to determining the capture rate as a function of the signal strength threshold. This may be achieved, for example, using the corrected defect distribution model.

Alternatively or additionally, the method of processing data derived from a sample may comprise processing an initial data set of elements derived from a detection by a detector for calibration. The data set comprising elements representing nuisance signals and detection signals, as described above (and elsewhere described herein). The processing of the initial data set comprises: fitting a distribution model; setting a signal strength value; selecting elements in the initial data set; fitting a distribution model to the set of selected elements; and determining a signal strength threshold. The fitting of the distribution model is to the initial data set to create a nuisance distribution model. The selecting elements in the initial data set selects those elements that have a magnitude greater than the signal strength value. The selected elements form a set of defect candidates. The fitting the distribution model to the set of defect candidates is to create a defect distribution model of detection signals. The determining a signal strength threshold is dependent on at least the defect distribution model, desirably where the defect distribution model has been corrected to be a corrected distribution model, as described above (and elsewhere described herein).

The processing of the initial data set comprises determining a relationship between capture rate and the signal strength threshold. Determining a relationship between capture rate and signal strength threshold comprises determining the capture rate as a function of the signal strength threshold.

The determining the signal strength threshold may comprise correcting for overlap in magnitude between elements representative of nuisance signals and defect signals, as described above (and elsewhere described herein). Desirably the correcting for overlap comprises correcting to a corrected defect distribution model. A corrected summed distribution model may be created by summing the nuisance distribution model and the defect the distribution model and fitting to an actual distribution of the initial dataset. The corrected defect distribution model may be based on parameter values of the corrected summed distribution model. Determining the capture rate as a function of signal strength threshold and/or determining a capture rate as a function of signal strength threshold is desirably based on parameter values of the corrected summed distribution model.

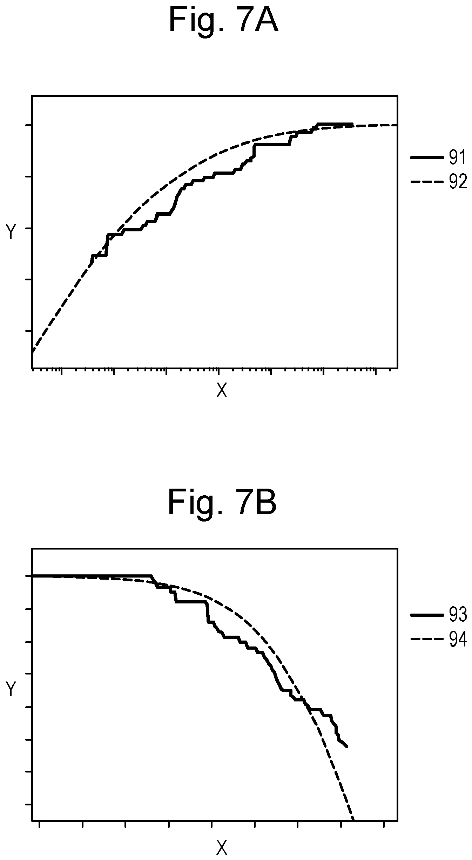

**FIG. 7A** shows a graph of capture rate on the Y-axis against nuisance rate on the X-axis. The actual data 91 is plotted as is the modelled data 92. (The modelled data 92 is based on nuisance and defect distribution contributions of the corrected summed distribution model). The signal strength threshold may be set automatically based on the corrected defect distribution model. Alternatively, or additionally, the user may adjust the signal strength threshold to achieve a balance between capture rate of defects and the nuisance rate. In other words, it may be desirable to select a signal strength threshold which has a high enough capture rate that a sufficient proportion of defects are captured, but at which the proportion of nuisance signals captured is low enough that further processing of the data is not overly inefficient; for example that the further processing of the data is not unreasonably inefficient. It is noted that any proportion of nuisance signals in the data for further processing slows the processing. Therefore in this arrangement a proportion of the nuisance signals in the data for further processing, including post-processing of the resulting data sets and images, and some resulting inefficiency is acceptable. However, that is correct to a point. If the proportion of nuisance signals in the data for further processing is too high, the further processing including post-processing is inefficient, possibly even to the extent that further processing becomes meaningless.

The signal strength threshold may be set based on a determined capture rate. For example, it may be desired that the capture rate of defects is at least 85%. The corrected defect distribution model may be used to determine at which signal strength 85% of the defects occur above that signal strength. **FIG. 7B** shows a graph of capture rate on the Y-axis against signal strength threshold on the X-axis. The actual data 93 is plotted as is the modelled data 94 (based on the corrected defect distribution model).

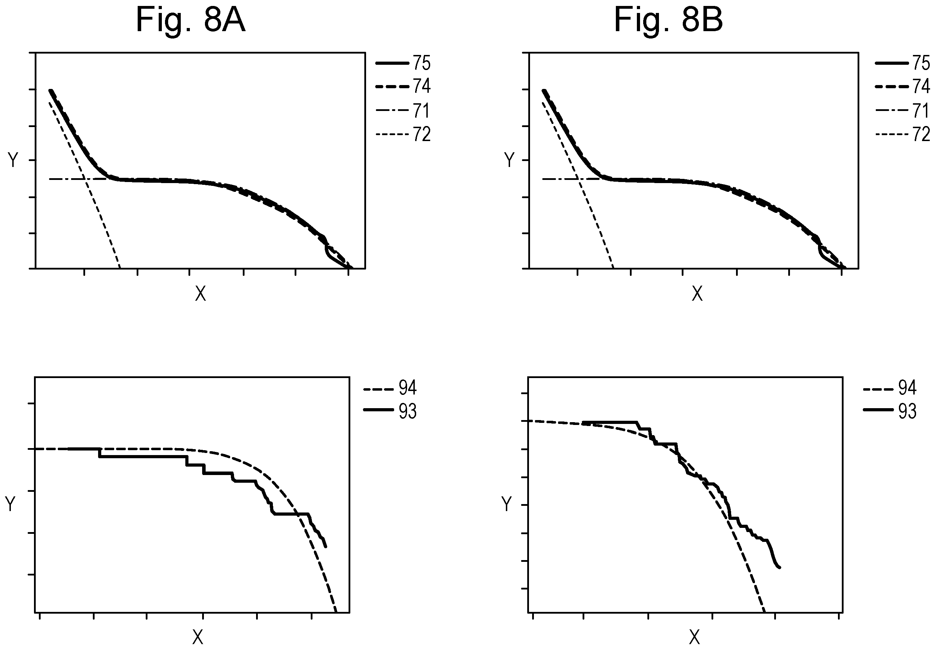

**FIG 8A and 8B** provide further examples comparing the corrected distribution models with the corresponding actual data. The initial data sets used to generate **FIG 8A and 8B** are based on images taken from a sample with pre-programmed defects, so the exact amount (or number) of actual defects and their location is known. A comparison can therefore be made between the corrected distribution model and the corresponding actual data. The upper graphs of **FIG. 8A and 8B** shows a graph representing the defect distribution model 71, the nuisance distribution model 72, the corrected summed distribution model 74 and the distribution of the initial data set 75, where the X-axis is representative of signal strength magnitude and the Y-axis is representative of occurrences. That is the upper graphs of **FIG 8A and 8B** represent similar parameters for different data as initial data sets, as depicted in and described with reference to **FIG. 6A**. The lower graphs of **FIG. 8A and 8B** show capture rate on the Y-axis against signal strength threshold on the X-axis. The actual data 93 is plotted as is the modelled data 94. (The modelled data 94 is based on the corrected defect distribution model). That is, for the same data as depicted in upper graphs of **FIG 8A and 8B,** the lower graphs representations of parameters as depicted in and described with reference to **FIG. 7B.** From these figures, it can be seen that the models provide a means to quantify the percentage of defects likely to be captured for a given signal strength threshold. This may enable the user to make a more efficient and informed selection of the signal strength threshold by using these models. Alternatively, or additionally, the signal strength threshold may be set automatically, such as by a computer being used, such a parameter such a boundary condition, to perform the data processing, based on the corrected defect distribution model.

As described above (and elsewhere described herein), the processing of the initial data set comprises setting the signal strength value and selecting elements in the initial data set. The selecting elements in the initial data set selects elements that have a magnitude greater than the signal strength value. The elements of the initial data set that are selected are selected as a set of defect candidates. The signal strength value may be set based on the nuisance distribution model.

For example, setting the signal strength value may comprise determining a nuisance threshold based on the nuisance distribution model. The nuisance threshold is representative of a signal strength magnitude above which the number of elements representing nuisance signals; the nuisance threshold is typically low. A predetermined nuisance threshold is set to represent a number of elements representing nuisance signals having a magnitude greater than the nuisance threshold. The nuisance threshold may then be determined based on the predetermined nuisance threshold and the nuisance distribution model. According to the nuisance distribution model, the number of elements representing nuisance signals that have a magnitude greater than the nuisance threshold is less than, or is equal to, the predetermined nuisance threshold. The predetermined nuisance threshold may be ten (10), desirably one (1), more desirably substantially negligible.

The signal strength value may be selected based on the nuisance threshold. The signal strength value is desirably set equal to the nuisance threshold. In this way the cut-off signal strength beyond which the elements are selected for inclusion in the set of defect candidates is based on the nuisance distribution model. The nuisance distribution model may indicate that there is a low occurrence of nuisance signals above a particular signal strength. The signal strength value may be set equal to the particular signal strength. Here the set of defect candidates is representative of detection signals (which are expected to be defect signals).

The nuisance distribution model may be based on the model:

$$\ln(y) = a + c*x^2 \qquad (1)$$

where y is the number of occurrences (e.g. the number of elements in a data set having a particular signal strength magnitude), x is the signal strength, and a and c are parameters values. The parameter values "a" and "c" are determined by fitting to the distribution of the initial data set.

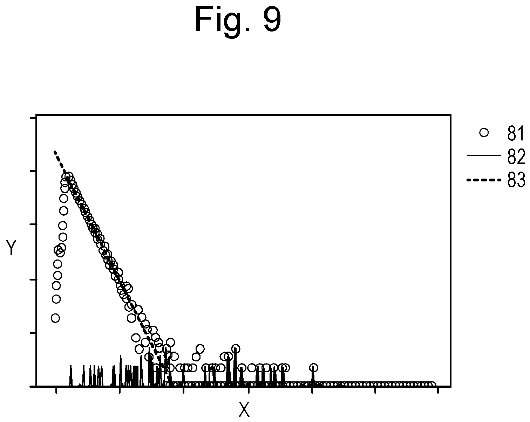

A distribution of an exemplary initial data set 81 is shown in FIG. 9, where the X-axis is the signal strength squared ($x^2$) and the Y-axis is the natural log of the number of occurrences. In this figure a first order polynomial 83 (or straight line) is fitted to the initial data 83, with the distribution showing linear behavior. The gradient of the first order polynomial is parameter "c" in equation (1). The Y-axis intercept of first order polynomial 83 is parameter "a" of equation (1). The X-axis intercept of the first order polynomial 83 may be used as the signal strength value, which is used to select elements of the initial data set for inclusion in the set of defect candidates. Elements of the initial data set which were found to represent actual defects are represented by actual defect line 82. Note that the distribution of actual defects as indicated by actual defect line 82 is present both sides, i.e. above and below, of the X-axis intercept of the first order polynomial 83. Thus some of the actual defects to the left of the X-axis intercept have not been included in the set of defect candidates to the right of the X-axis intercept.

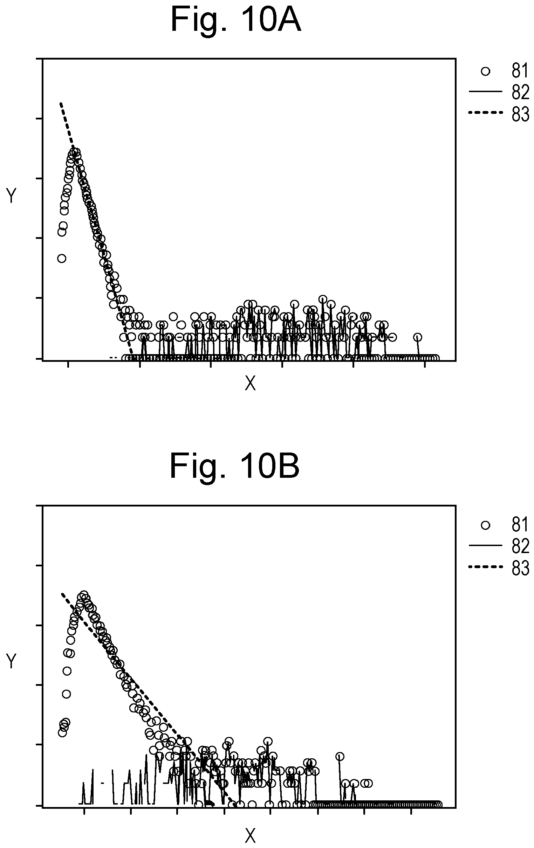

FIG. 10A and 10B show distributions similar to that of FIG. 9. The distributions of FIG. 10A and 10B have been generated by applying the model defined by equation (1) on two further example initial data sets. These example initial data sets have a known underlying distribution of nuisance and actual defects. These initial data sets are based on images taken from a sample with pre-programmed (or pre-determined or known) defects, so the exact amount (or number) of actual defects and their location is known. A comparison can therefore be made between model, for example represented by line (or first order polynomial) 83 and actual data (for example the initial data set) 81. FIG. 10A and 10B demonstrate that the distribution of nuisance signals can be modelled for different initial data sets which have, for example, different distributions of nuisance signals, resulting in different gradients of the nuisance model, i.e. the first order polynomial 83. In this way a signal strength value can be determined for each of the initial data sets, such that the set of defect candidates is likely to capture mostly signals representative of actual defects.

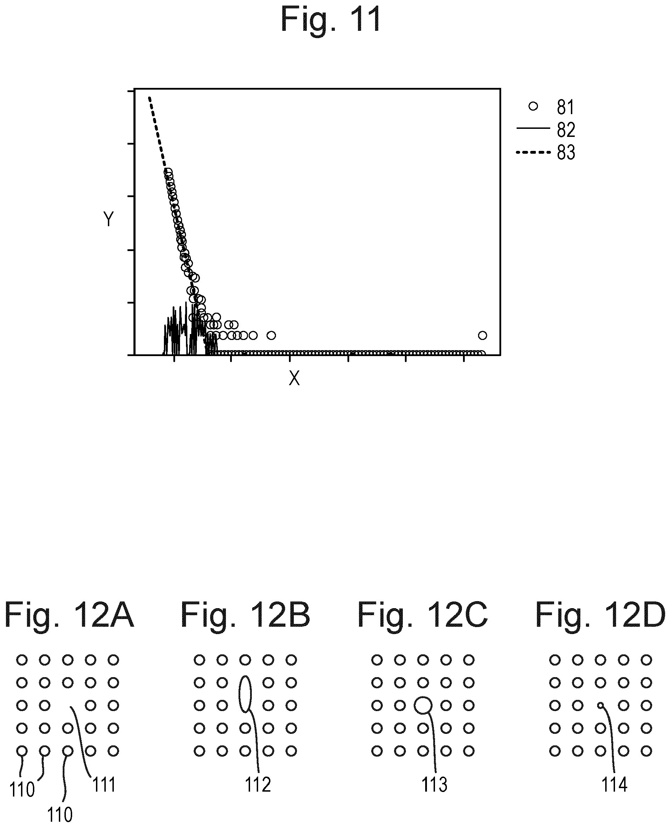

Alternatively or additionally, a method of processing data derived from a sample, may comprise processing an initial data set of elements derived from a detection by a detector. Such a data set comprises elements representing nuisance signals and defect signals as described above (and elsewhere described herein) with reference to FIG. 5. A nuisance distribution comprises the elements representing nuisance signals having a nuisance range in magnitude. A defect distribution comprises the elements representing detection signals having a defect range in magnitude. The nuisance range overlaps with the defect range. Where the nuisance range overlaps the defect range is an overlap. For example, a sufficient number of elements in the defect range have a magnitude exceeding an upper limit of the nuisance range for a good prediction. For a good prediction an upper limit of the defect range is above the upper limit of the nuisance range. That is, the magnitude of the of the defect range, i.e. in signal strength, exceeds, e.g. extends above, the upper limit of the nuisance range, i.e. in magnitude. Where a lower limit of the defect range is below the upper limit of the nuisance range is the overlap. That is, a lower limit of the overlap is the lower limit of the defect range in magnitude that extends below, or is exceeded by, the upper limit of the nuisance range. A sufficient number is a number of elements of the defect range that is sufficient to estimate the distribution of defect signals, given other parameters of the distribution of the initial data set. With a sufficient number of elements of the defect range, the distribution of defect signals can be sufficiently distinct for an estimate of the distribution of defect signals to be distinguished from the nuisance distribution. The sufficient number of elements of the defect range may be a threshold number of elements of the defect range having a magnitude larger than the upper limit of the nuisance range. When a number of elements of the defect range matches or exceeds the threshold number, the defect distribution is distinct and may be distinguishable from the nuisance distribution. Fig. 11 shows that 1% of the actual defects being included in the set of defect candidates is insufficient; whereas in Fig. 10B about 50% of the actual defects being included in the set of defect candidates and in **Fig. 10A** much more than 50% of the actual defects being included in the set of defect candidates. So, the threshold of the proportion of the elements of the defect distribution that are separate and distinct to enable a good prediction is between the results depicted in **Figs. 10B and 11.** That is the threshold of the proportion of the elements of the defect distribution which occur in the nuisance range is: more than half to more than de minimus (so not all of the defect distribution), or between 1 and 50%, or (alternatively expressed) the proportion of the defect distribution having a signal strength magnitude above the signal strength value is less than half (50%) for example between 1 and 50%. Thus, in principle, a least one defect element of the defect distribution having a signal strength magnitude that exceeds upper limit of the nuisance distribution could be a sufficient number of defects. However the number of defect elements of the defect distribution for a sufficient number of defects to exceed the magnitude of the upper limit of the nuisance distribution is likely to be more than one.

The defect distribution may be separate/distinct from the nuisance distribution. The at least one element represents detection signals comprising a sub-set of the elements representing detection signals. Desirably the subset of the elements representing detection signals is indicative of the defect distribution being separate/distinct from the nuisance distribution. The initial data sets depicted in and described with reference to **FIG. 9, 10A and 10B** have such defect distributions.

**FIG. 11** shows a graph similar to that of **FIG. 9,** which has been generated by applying the model defined by equation (1) on another example initial data set. In this data set, the nuisance range completely overlaps with the defect range, desirably across the defect distribution. The defect range is wholly within the nuisance range or otherwise has an insufficient number of elements that are separate and distinct from the nuisance range for a good prediction of the distribution of defect signals (e.g. for an estimate of the defect distribution to be distinguished from the nuisance distribution). It can be seen that the defects signals represented by the actual defect line 82 occur in a range in close proximity to the upper end of the range of nuisance data and the nuisance model i.e. the first order polynomial 83. In other words, the distribution of defect signals, as represented by the actual defect line 82 completely or at least substantially (almost completely) overlaps with the distribution of nuisance signals i.e. the first order polynomial 83.

The defect distribution as depicted in **Fig. 11** by the actual defect line 82 may be indistinct or inseparable (e.g. not separable) from the nuisance distribution for example represented by line (or first order polynomial) 83. Unlike the arrangements depicted in **Figs 9, 10A and 10B,** which show the distribution of defect signals as distinct from the distribution of nuisance signals, the elements of the initial data set that are defect candidates is close to an empty set. That is there are no or not enough defect signals are separate and distinct from the nuisance signals of the nuisance distribution. There are no, or there is at most an insufficient number, of defect signals that have a defect range with a magnitude that exceeds an upper limit of the nuisance range at an element with corresponding signal strength magnitude. That is the number of elements of the defect range having a magnitude exceeding the upper limit of the nuisance range does not reach the threshold of elements of the defect range having a magnitude larger than the upper limit nuisance range. Therefore a condition exists where the defect signals in the initial data set can be identified based on the relative signal strengths of the defect distribution compared to the nuisance distribution.

The initial data set may be identified from an initial signal (or inspection signal or assessment signal) from a detector. The initial data set may include all elements of the initial signal, as detected by the detector. However, with this approach there is the disadvantage that large amounts of data are processed, most of which are nuisance signals. Alternatively, the initial data set may be identified by: extracting elements from the initial signal; and selecting the elements having a magnitude greater than a predetermined signal strength value. The processing of the initial data set is desirably performed using the selected elements. In this way, elements having a magnitude low enough to be indicative of a nuisance signal can be filtered out at an early stage, before the initial data set is processed as described above (and elsewhere described herein). The processing may therefore be more efficient. Desirably, the predetermined signal strength value is lower than the signal strength value. In this way any, elements having a magnitude high enough to be indicative of a possible defect are unlikely to be discarded, but instead will be included in the initial data set. This advantageously provides an initial data set having a low quantity of nuisance data with a low risk of inadvertently omitting data representing an actual defect. The predetermined signal strength value may be set based on information of previous comparable data sets, or based on a model.

Once the signal strength threshold has been set, for example by using the methods described above (and elsewhere described herein), defects on the sample may be detected. The defects may be detected by evaluating a sub-set of defect candidates having a magnitude greater than the signal strength threshold. In other words, the sub-set of defect candidates may be evaluated to determine which of the sub-set of defect candidates correspond to actual defects. Once an actual defect is determined, the corresponding signal can be further evaluated to determine the type of defect. The evaluation of signals to identify and classify defects can take considerable time and computational effort. It is therefore preferable to use the above described methods (and elsewhere described herein) to set an appropriate signal strength threshold such that detailed evaluation is not performed on large amounts of signals including mostly nuisance signals.

The signal strength threshold may be set and used to determine defects by evaluating a subset of defect candidates based on the initial data set. Alternatively or additionally, the initial data set may be used to determine the signal strength threshold which can be applied to further, subsequently processed and/or gathered signal data. For example, an initial data set based on data of a single sample, or part of a single sample, may be used to determine the signal strength threshold. Following this determination of the signal strength threshold, further initial signals may be received and/or processed. The further initial signals may be derived from inspection of another sample from the same batch as the single initial sample. The further initial signals may be derived from inspection of the remainder of the single sample, if data of only part of the single initial sample was used to determine the signal strength threshold. Further elements of the further initial signals, having a magnitude greater than the signal strength threshold, may be extracted as further detection signals. The further detection signals may be evaluated to determine which of the further detection signals correspond to actual defects.

Optionally, the further detection signal may be put in the sub-set of defect candidates, together with the sub-set of defect candidates identified from the initial data set. In this way actual defects in both the initial data set and the further detection signals may be evaluated to determine which of the further detection signals correspond to actual defects.

FIG. 12A-D illustrate samples having a plurality of features 110 one or more of which is not formed correctly and thus is considered a defect. Data of such defects depicted and described herein may comprise, for example populate, the defects of the defect distribution such as the defects distribution of the initial data set (as the actual defects). FIG. 12A illustrates an example in which the defect is a missing feature, e.g. a hole, on the sample in the center of the depicted area. The image could be analyzed to classify that the defect takes the form of a missing hole 111. The type of defect may be classified by comparing the mismatched signal with the other signals to determine that the mismatched signal mismatches the other signals, where the other signals are similar and so match with each other. Alternatively, the type of defect may be classified by comparing the mismatched signal with a known, expected signal pattern for that area of the sample. The expected signal pattern may take the form of a datafile which is compared with the mismatched signal.

FIG. 12B illustrates an example in which the defect is a bridge feature 112. In particular, FIG. 12B depicts a sample comprising a series of circular features on its surface. The bridge feature 112 is elongated, for example forming an elliptical, rectangular or irregular shape, rather than a circular shape. FIGs 12C and 12D illustrate examples in which the defect is a feature which is the wrong size. In particular, FIG. 12C depicts a sample comprising an oversized feature 113 and FIG. 12D depicts a sample comprising an undersized feature 114.

There is provided the following clauses:

Clause 1: A method of processing data derived from a sample, comprising processing an initial data set of elements derived from a detection by a detector for calibration, the data set comprising elements representing nuisance signals and detection signals, the processing of the initial data set comprising: fitting a distribution model to the initial data set to create a nuisance distribution model; setting a signal strength value, and selecting elements in the initial data set having a magnitude greater than the signal strength value as a set of defect candidates; fitting a distribution model to the set of defect candidates to create a defect distribution model of detection signals; and determining a signal strength threshold dependent on at least the defect distribution model, the determining comprising correcting the defect distribution model, desirably the correcting being suitable for correcting for overlap in magnitude between elements representative of nuisance signals and detection signals.

Clause 2: The method of clause 1, wherein the correcting for overlap comprises correcting to a corrected defect distribution model of detection signals.

Clause 3: The method of clause 2, wherein the correcting for overlap comprises creating a summed distribution model of the initial data set using the nuisance distribution model and the defect distribution model.

Clause 4: The method of clause 3, wherein creating the summed distribution model comprises summing the nuisance distribution model and the defect distribution model.

Clause 5: The method of either of clauses 3 and 4, further comprising fitting the summed distribution model to an actual distribution of the initial dataset to create a corrected summed distribution model.

Clause 6: The method of clause 5, wherein the correcting for overlap comprises creating the corrected defect distribution model by adjusting parameter values of the defect distribution model based on parameter values of the corrected summed distribution model.

Clause 7: The method of clause 5, wherein the correcting for overlap comprises creating the corrected defect distribution model based on parameter values of the corrected summed distribution model associated with the defect distribution model.

Clause 8: The method of any one of clauses 2 to 7, wherein setting the signal strength threshold is based on parameter values of the corrected defect distribution model.

Clause 9: The method of any preceding clause, further comprising determining a relationship between capture rate and the signal strength threshold, desirably determining the capture rate as a function of the signal strength threshold.

Clause 10: A method of processing data derived from a sample, comprising processing an initial data set of elements derived from a detection by a detector for calibration, the data set comprising elements representing nuisance signals and detection signals, the processing of the initial data set comprising: fitting a distribution model to the initial data set to create a nuisance distribution model; setting a signal strength value and selecting elements in the initial data set having a magnitude greater than the signal strength value as a set of defect candidates; fitting a distribution model to the set of defect candidates to create a defect distribution model of detection signals; determining a signal strength threshold dependent on at least the defect distribution model; and determining a relationship between capture rate and the signal strength threshold.

Clause 11: The method of clause 10, wherein the determining the signal strength threshold comprises correcting for overlap in magnitude between elements representative of nuisance signals and detection signals, desirably the correcting for overlap comprising correcting to a corrected defect distribution model desirably using a corrected summed distribution model by summing the nuisance distribution model and the defect the distribution model and fitting to an actual distribution of the initial dataset.

Clause 12: The method of any of clauses 9 to 11, wherein determining a relationship between capture rate and signal strength threshold comprises determining the capture rate as a function of the signal strength threshold.

Clause 13: The method of clause 12, wherein the determining the capture rate as a function of signal strength threshold is based on parameter values of the corrected summed distribution model.

Clause 14: The method of clause 13, comprising determining a capture rate as a function of signal strength threshold based on the corrected defect distribution model.

Clause 15: The method of any one of clauses 13 or 14, further comprising setting a signal strength threshold based on a determined capture rate.

Clause 16: The method of any of clauses 1 to 15, wherein the nuisance distribution model comprises a Gaussian function.

Clause 17: The method of any of clauses 1 to 16, wherein the defect distribution model comprises a Gaussian function.

Clause 18: The method of any one of clauses 5 to 9 and 11 to 17, wherein the summed distribution model and the actual distribution are each a log of the inverse of a respective cumulative distribution, desirably the corrected summed distribution model is a log of the inverse of a respective cumulative distribution.

Clause 19: The method of any one of clauses 1 to 18, wherein the signal strength value is set based on the nuisance distribution model.

Clause 20: The method of clause 19, wherein setting a signal strength value comprises: determining a nuisance threshold based on the nuisance distribution model, wherein according to the nuisance distribution model the number of elements representing nuisance signals having a magnitude greater than the nuisance threshold is less or equal to a predetermined nuisance threshold; and selecting the signal strength value based on the nuisance threshold.

Clause 21: The method of clauses 20, wherein the signal strength value is set equal to the nuisance threshold.

Clause 22: The method of either of clauses 20 and 21, wherein the predetermined nuisance threshold is 1.

Clause 23: The method of any one of clauses 1 to 22, wherein the nuisance distribution model is based on the model: $\ln(y) = a + c \cdot x^2$ wherein, $y$ is the number of occurrences, $x$ is the signal strength, and $a$ and $c$ are parameters values determined by fitting to the distribution of the initial data set.

Clause 24: The method of any one of clauses 1 to 23, further comprising receiving a detection signal from a detector; and identifying the initial data set from the detection signal.

Clause 25: The method of any one of clauses 1 to 24, further comprising identifying the initial data set by: extracting elements from the detection signal; and selecting the elements having a magnitude greater than a predetermined signal strength value, wherein the predetermined signal strength value is lower than the signal strength value; wherein the processing of the initial data set is performed using the selected elements.

Clause 26: The method of any one of clauses 1 to 25, wherein the processing of the initial data set further comprises identifying a sub-set of defect candidates having a magnitude greater than the signal strength threshold.

Clause 27: The method of any one of clauses 1 to 26, further comprising receiving a further initial signal; and extracting further elements having a magnitude greater than the signal strength threshold from the further initial signal; desirably including the further elements in a set of defect candidates, desirably the further elements may be referred to as a sub-set of defect candidates.

Clause 28: The method of either of clauses 26 and 27, wherein the processing of the initial data set further comprises detecting defects on the sample by evaluating the sub-set of defect candidates.

Clause 29: The method of any one of clauses 1 to 28, wherein the processing data derived from the sample further comprises using a processor comprised in a charged particle optical apparatus.

Clause 30: The method of any one of clauses 1 to 29 further comprising projecting at least a beam of charged particles towards a sample using a charged particle optical device comprising a detector, the detector detecting the detection signal in response to a signal particle received from the sample in response to an impact of the beam with the sample.

Clause 31: A method of processing data derived from a sample, comprising processing an initial data set of elements derived from a detection by a detector, the data set comprising elements representing nuisance signals and defect signals, a nuisance distribution comprises the elements representing nuisance signals having a nuisance range in magnitude and a defect distribution comprises the elements representing detection signals having a defect range in magnitude, wherein the nuisance range overlaps with the defect range, desirably in an overlap, and at least one element of the defect range has a magnitude exceeding an upper limit of the nuisance range, desirably in magnitude, desirably exceeding above the upper limit of the nuisance range, desirably the at least one element of the defect range is a sufficient number of elements of the defect range for the defect distribution to be distinct from the nuisance distribution, the sufficient number may be or may exceed a threshold number of elements of the defect range having a magnitude larger than the upper limit of the nuisance range desirably so that the defect distribution is distinct from the nuisance distribution.

Clause 32: The method of clause 31, wherein the defect distribution is separate/distinct from the nuisance distribution.

Clause 33: The method of either of clauses 31 and 32, wherein the at least one element represents detection signals comprising a sub-set of the elements representing detection signals, desirably the subset of the elements representing detection signals is indicative of the defect distribution being separate/distinct from the nuisance distribution.

Clause 34: The method of processing data derived from a sample of any of clauses 31 to 33, comprising the method of any of clauses 1 to 30.

Clause 35: A method of assessing a sample comprising the method of any of clauses 1 to 34.

Clause 36: A method of identifying defect candidates, comprising processing a data set of elements derived from a detection by a detector, the data set comprising elements representing nuisance signals and detection signals, a capture-threshold relationship between capture rate and a signal strength threshold having been calibrated using an initial data set, the processing comprising: setting a signal strength threshold by selecting a capture rate and based on the capture-threshold relationship; and processing the data set using the signal strength threshold to select elements representative of detection signals.

Clause 37: The method of clauses 36, wherein the processing comprising selecting elements representative of detection signals by identifying a sub-set of defect candidates having a magnitude greater than the signal strength threshold.

Clause 38: The method of either of clause 37, wherein the processing further comprises detecting defects on the sample by evaluating the sub-set of defect candidates.

Clause 39: The method of any of clauses 36 to 38, further comprising: receiving a detection signal comprising the data set; and within the processing, extracting the elements representative of detection signals.

Clause 40: The method of identifying defect candidates of clause 36 to 39, wherein determining the capture-threshold relationship in calibrating using the initial data set, using the method of processing data of any of clauses 9 to 30, desirably based on the relationship between capture rate and the signal strength threshold.

Clause 41: A processing apparatus comprising: a processor configured to perform the processing according to any of clauses 1 to 40.

Clause 42: A computer program comprising instructions configured to control a processor to perform the method of any of the clauses 1 to 40.

Clause 43: An assessment system identifying defect candidates in assessment data derived from a sample, the assessment system comprising: as detector configured to generate a detection signal representative of a one more characteristics of a sample; a processor configure to: process a data set of elements derived from a detection by the detector, the data set comprising elements representing nuisance signals and detection signals, set a signal strength threshold by selecting a capture rate and based on a capture-threshold relationship between capture rate and a signal strength threshold, the capture relationship calibration being pre-calibrated with an initial data set; and process the data set using the signal strength threshold to select elements representative of detection signals.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. For example, a voltage supply may be electrically connected to one or more components to apply potentials to the components, such as in a non-limited list the control lens array 250, the objective lens array 241, the condenser lens 231, correctors, a collimator element array and scan deflector array 260, under the control of the controller or control system or control unit. An actuatable component, such as a stage, may be controllable to actuate and thus move relative to another component such as the beam path using one or more controllers, control systems, or control units to control the actuation of the component.

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

A computer program may comprise instructions to instruct the controller 50 to perform the following steps. The controller 50 controls the charged particle beam apparatus to project a charged particle beam towards the sample 208. In an embodiment the controller 50 controls at least one charged particle-optical element (e.g. an array of multiple deflectors or scan deflectors 260) to operate on the charged particle beam in the charged particle beam path. Additionally or alternatively, in an embodiment the controller 50 controls at least one charged particle-optical element (e.g. the detector 240) to operate on the charged particle beam emitted from the sample 208 in response to the charged particle beam.

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical column 40 may be a component of an assessment system, such as an inspection tool or a metro-inspection tool. Any reference to a tool herein is intended to encompass a device, apparatus or system, the tool comprising various components which may or may not be collocated, and which may even be located in separate rooms, especially for example for data processing elements.

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

The descriptions above are intended to be illustrative, not limiting. Thus, it will be apparent to one skilled in the art that modifications may be made as described without departing from the scope of the claims and clauses set out herein.

**Claims**

1. A method of processing data derived from a sample, comprising processing an initial data set of elements derived from a detection by a detector for calibration, the data set comprising elements representing nuisance signals and detection signals, the processing of the initial data set comprising:

   fitting a distribution model to the initial data set to create a nuisance distribution model;
   setting a signal strength value, and selecting elements in the initial data set having a magnitude greater than the signal strength value as a set of defect candidates;
   fitting a distribution model to the set of defect candidates to create a defect distribution model of detection signals; and
   determining a signal strength threshold dependent on at least the defect distribution model, the determining comprising correcting the defect distribution model, desirably the correcting being suitable for correcting for overlap in magnitude between elements representative of nuisance signals and detection signals.

2. The method of claim 1, wherein the correcting for overlap comprises correcting to a corrected defect distribution model of detection signals.

3. The method of claim 2, wherein the correcting for overlap comprises creating a summed distribution model of the initial data set using the nuisance distribution model and the defect distribution model.

4. The method of claim 3, wherein creating the summed distribution model comprises summing the nuisance distribution model and the defect distribution model.

5. The method of either of claims 3 and 4, further comprising fitting the summed distribution model to an actual distribution of the initial dataset to create a corrected summed distribution model.

6. The method of claim 5, wherein the correcting for overlap comprises creating the corrected defect distribution model based on parameter values of the corrected summed distribution model associated with the defect distribution model.

7. The method of any one of claims 2 to 6, wherein setting the signal strength threshold is based on parameter values of the corrected defect distribution model.

8. The method of any preceding claim, further comprising determining a relationship between capture rate and the signal strength threshold, desirably determining the capture rate as a function of the signal strength threshold.

9. The method of any of claims 8, wherein determining a relationship between capture rate and signal strength threshold comprises determining the capture rate as a function of the signal strength threshold.

10. The method of claim 9, wherein the determining the capture rate as a function of signal strength threshold is based on parameter values of the corrected summed distribution model.

11. The method of any of claims 1 to 10, wherein the nuisance distribution model comprises a Gaussian function and/or, wherein the defect distribution model comprises a Gaussian function.

12. The method of any one of claims 5 to 11, wherein the summed distribution model and the actual distribution are each a log of the inverse of a respective cumulative distribution, desirably the corrected summed distribution model is a log of the inverse of a respective cumulative distribution.

13. The method of any one of claims 1 to 12, wherein the signal strength value is set based on the nuisance distribution model.

14. The method of claim 13, wherein setting a signal strength value comprises:

determining a nuisance threshold based on the nuisance distribution model, wherein according to the nuisance distribution model the number of elements representing nuisance signals having a magnitude greater than the nuisance threshold is less or equal to a predetermined nuisance threshold; and
selecting the signal strength value based on the nuisance threshold.

15. The method of any one of claims 1 to 14, further comprising

receiving a detection signal from a detector; and identifying the initial data set from the detection signal.

# Fig. 1

# Fig. 2

# Fig. 3

# Fig. 4

# Fig. 5

# Fig. 6A

- ——— 71
- ------- 72
- —·—·— 73
- ------- 74
- ——— 75

# Fig. 6B

- ——— 71
- ------- 72
- —·—·— 73
- ------- 74
- ——— 75

# Fig. 7A

—— 91
– – 92

# Fig. 7B

—— 93
– – 94

# Fig. 8A

- —— 75
- --- 74
- ·—· 71
- ---- 72

# Fig. 8B

- —— 75
- --- 74
- ·—· 71
- ---- 72

- --- 94
- —— 93

- --- 94
- —— 93

EP 4 300 087 A1

# Fig. 9

# Fig. 10A

# Fig. 10B

# Fig. 11

# Fig. 12A  Fig. 12B  Fig. 12C  Fig. 12D

Europäisches
Patentamt

European
Patent Office

Office européen
des brevets

## EUROPEAN SEARCH REPORT

Application Number

EP 22 18 1883

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 8 712 184 B1 (LIAO CHAD [TW] ET AL) 29 April 2014 (2014-04-29) * column 1, line 1 - column 2, line 26 * * column 2, line 55 - column 4, line 40; figures * | 1-15 | INV. G01N23/2251 H01J37/00 |
| A | US 2019/067060 A1 (PLIHAL MARTIN [US] ET AL) 28 February 2019 (2019-02-28) * paragraph [0049] - paragraph [0052] * * paragraph [0080] * * paragraph [0094] - paragraph [0109] * | 1-15 | |
| A | US 2021/125325 A1 (HUANG TONG [US] ET AL) 29 April 2021 (2021-04-29) * paragraph [0054] - paragraph [0069] * * paragraph [0003] - paragraph [0006] * | 1-15 | |
| A | WO 2022/106143 A1 (ASML NETHERLANDS BV [NL]) 27 May 2022 (2022-05-27) * paragraph [0003] - paragraph [0004] * * paragraph [0083] - paragraph [0085] * | 1-15 | TECHNICAL FIELDS SEARCHED (IPC) |
| A | US 2019/383753 A1 (ZHANG QIANG [US] ET AL) 19 December 2019 (2019-12-19) * paragraph [0006] - paragraph [0011] * * paragraph [0020] - paragraph [0024] * * paragraph [0028] - paragraph [0033] * * paragraph [0036] - paragraph [0040] * | 1-15 | G01N H01J |
| A | US 2019/186909 A1 (MACK CHRIS [US]) 20 June 2019 (2019-06-20) * paragraph [0003] * * paragraph [0083] - paragraph [0110] * * paragraph [0124] - paragraph [0125] * | 1-15 | |

The present search report has been drawn up for all claims

| Place of search | Date of completion of the search | Examiner |
|---|---|---|
| The Hague | 25 November 2022 | Savage, John |

EPO FORM 1503 03.82 (P04C01)

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

## ANNEX TO THE EUROPEAN SEARCH REPORT
## ON EUROPEAN PATENT APPLICATION NO.

EP 22 18 1883

This annex lists the patent family members relating to the patent documents cited in  the above-mentioned European search report.
The members are as contained in the European Patent Office EDP file on
The European Patent Office is in no way liable for these particulars which are merely given for the purpose of information.

25-11-2022

| Patent document cited in search report | | | Publication date | Patent family member(s) | | | Publication date |
|---|---|---|---|---|---|---|---|
| US 8712184 | B1 | | 29-04-2014 | NONE | | | |
| US 2019067060 | A1 | | 28-02-2019 | CN | 111052331 | A | 21-04-2020 |
| | | | | IL | 272364 | A | 31-03-2020 |
| | | | | KR | 20200037869 | A | 09-04-2020 |
| | | | | TW | 201921542 | A | 01-06-2019 |
| | | | | US | 2019067060 | A1 | 28-02-2019 |
| | | | | WO | 2019046428 | A1 | 07-03-2019 |
| US 2021125325 | A1 | | 29-04-2021 | CN | 114600156 | A | 07-06-2022 |
| | | | | IL | 292137 | A | 01-06-2022 |
| | | | | KR | 20220083754 | A | 20-06-2022 |
| | | | | TW | 202134641 | A | 16-09-2021 |
| | | | | US | 2021125325 | A1 | 29-04-2021 |
| | | | | WO | 2021080888 | A1 | 29-04-2021 |
| WO 2022106143 | A1 | | 27-05-2022 | EP | 4001903 | A1 | 25-05-2022 |
| | | | | WO | 2022106143 | A1 | 27-05-2022 |
| US 2019383753 | A1 | | 19-12-2019 | CN | 112219111 | A | 12-01-2021 |
| | | | | KR | 20210010948 | A | 28-01-2021 |
| | | | | TW | 202001230 | A | 01-01-2020 |
| | | | | US | 2019383753 | A1 | 19-12-2019 |
| | | | | US | 2020292468 | A1 | 17-09-2020 |
| | | | | WO | 2019245830 | A1 | 26-12-2019 |
| US 2019186909 | A1 | | 20-06-2019 | NONE | | | |

EPO FORM P0459

For more details about this annex : see Official Journal of the European Patent Office, No. 12/82

**EP 4 300 087 A1**

**Patent documents cited in the description**

- US 2020118784 A
- US 20200203116 A
- US 20190259570 A
- US 20190259564 A
- EP 1602121 A1
- EP 20156253
- US 20210319977 A1